# EUROPÄISCHE PATENTSCHRIFT

(11) **EP 3 574 532 B1**
(45) Veröffentlichungstag und Bekanntmachung des Hinweises auf die Patenterteilung: **03.03.2021**
(21) Anmeldenummer: 18704165.2
(22) Anmeldetag: 26.01.2018
(51) Int. Cl.: H01L 45/00

(54) **METALL-ISOLATOR-GRAPHEN DIODE**
METAL-INSULATOR-GRAPHENE DIODE
DIODE MÉTAL-ISOLANT-GRAPHÈNE

(30) Priorität: 26.01.2017 DE 102017101575
(43) Veröffentlichungstag der Anmeldung: 04.12.2019
(73) Patentinhaber: AMO GmbH, 52074 Aachen (DE)
(72) Erfinder: WANG, Zhenxing, 52134 Herzogenrath NRW (DE); NEUMAIER, Daniel, 52159 Roetgen NRW (DE); RIBEIRO, Mário, Alberto, Oliveira, 4930-607 Valença (PT)
(74) Vertreter: Patentanwälte Bauer Vorberg Kayser
(86) Internationale Anmeldenummer: PCT/EP2018/051976
(87) Internationale Veröffentlichungsnummer: WO 2018/138275

(56) Entgegenhaltungen:
- US-A1- 2014 346 558
- ROBERTO URCUYO ET AL: "High Performance Graphene-Oxide-Metal Diode through Bias-Induced Barrier Height Modulation", ADVANCED ELECTRONIC MATERIALS, Bd. 2, Nr. 9, 1. September 2016 (2016-09-01), Seite 1600223, XP055309138, ISSN: 2199-160X, DOI: 10.1002/aelm.201600223 in der Anmeldung erwähnt
- ZIXU ZHU ET AL: "Graphene geometric diodes for terahertz rectennas", JOURNAL OF PHYSICS D: APPLIED PHYSICS, INSTITUTE OF PHYSICS PUBLISHING LTD, GB, Bd. 46, Nr. 18, 15. April 2013 (2013-04-15), Seite 185101, XP020243858, ISSN: 0022-3727, DOI: 10.1088/0022-3727/46/18/185101

## Beschreibung

Die Erfindung bezieht sich auf eine Metall-Isolator-Graphen Diode. Dioden allgemein werden in der Elektronik verwendet, um Signale gleichzurichten, sie werden aber auch, da sie eine nichtlineare Kennlinie aufweisen, in Mischerstufen und anderen Frequenzumsetzern verwendet. Die anmeldungsgemäße Diode ist insbesondere für Höchstfrequenzanwendungen, insbesondere im THz-Bereich, bestimmt.

Die maximale Arbeitsfrequenz einer Diode ist häufig ein begrenzender Faktor. Es gibt eine Reihe von Untersuchungen und Ansätzen, um die Arbeitsgeschwindigkeit einer Diode zu erhöhen. Dabei ist insbesondere anmeldungsgemäß an eine Diode gedacht, die in Dünnfilmtechnologie und/oder auf flexiblen Substraten einsetzbar ist. Für konventionelle Dioden ist dies nicht gegeben.

Allgemein bekannt sind Halbleiterdioden, insbesondere mit pn-Übergängen. Zusätzlich gibt es auch sogenannte Schottky-Dioden und weiterhin Metall-Isolator-Metall Dioden (MIM-Diode), bei denen zwei Metallelektroden durch einen dünnen Isolator beabstandet sind und eine Anordnung, wie man sie bei einem Plattenkondensator antrifft, bilden. Diese MIM-Dioden haben eine hohe Arbeitsgeschwindigkeit, haben aber auch einen gewissen Kapazitätswert, sie haben in der Regel eine geringe Stromdichte und eine geringe Reproduzierbarkeit. Eine Verbesserung einer derartigen MIM-Diode wurde in 2011 vorgeschlagen, dabei wurde die eine Metallelektrode durch eine Graphen-Elektrode ersetzt. Hierzu wird auf US 9,202,945 B2 verwiesen. Bei dieser vorbekannten Diode, MIG-Diode genannt, ist zwischen einer Graphenschicht und einer Metallelektrode ein Isolator angeordnet, hierdurch wird wiederum ein Kondensator mit parallelen Platten gebildet, die grundsätzliche geometrische Anordnung unterscheidet sich nicht von einer MIM-Diode. Dieser neue Ansatz war mit dem Ziel unternommen worden, die Reproduzierbarkeit derartiger Dioden zu verbessern. Ein experimenteller Bericht über eine solche MIG-Diode findet sich in ADv. Electron.Mat.2016, 1600223.

Diese bekannte MIG-Diode nach dem US-Patent hat zwei wesentliche Nachteile: Der Kapazitätswert ist relativ hoch, dies ist durch den Kondensator mit parallelen Platten bedingt. Der Kapazitätswert ist vergleichbar mit demjenigen der MIM-Dioden. Weiterhin sind die erreichten Stromdichten relativ gering. Beides ist kritisch für Hochfrequenzanwendungen.

Dokument US 2014/346558 A1 zeigt eine Diode bestehend aus einer Metallelektrode, die eine Elektrodenfläche hat, einer Isolatorschicht, die mit einer ersten Hauptfläche in flächigem Kontakt mit der Elektrodenfläche ist, und mit einer Nanoröhre oder einem Nanodraht (aus Kohlenstoff, Metall, oder Halbleiter), die/der eine Kontaktfläche hat, die in punktförmigem Kontakt mit einer zweiten, der Elektrode gegenüber liegenden Hauptfläche der Isolatorschicht ist, wobei die Achse der Nanoröhre oder des Nanodrahts quer zu den Hauptflächen der Isolatorschicht verläuft.

Hiervon ausgehend ist es Aufgabe der Erfindung, die vorbekannte Diodenstruktur weiter dahingehend zu verbessern, dass der Kapazitätwert deutlich verringert wird und/oder die Stromdichte spürbar erhöht wird.

Diese Aufgabe wird gelöst durch die MIG-Diode mit den Merkmalen des Anspruchs 1.

Im Gegensatz zum Stand der Technik liegt die Graphenschicht nicht mit ihrer Bindungsebene parallel zur zweiten Hauptfläche der Isolatorschicht, vielmehr verläuft die Bindungsebene quer und insbesondere rechtwinklig zu dieser zweiten Hauptfläche. Dadurch ist der Wert der Kapazität zwischen der Metallelektrode und der Graphenschicht deutlich geringer als im Stand der Technik.

Unter Graphenschicht wird mindestens eine zweidimensionale Monolage Graphen verstanden, es können auch mehrere Monolagen übereinander angeordnet sein. Die Bindungsebene fällt mit der Flächenebene dieser mindestens eine Monolage der Graphenschicht zusammen. Bekanntlich ist eine Monolage graphisch darstellbar durch eine flächenfüllende, zweidimensionale Aneinanderreihung von Sechsecken. Eine entsprechende Struktur findet man bei Blick auf Bienenwaben. Die Sechsecke sind C-Ringstrukturen. Für die erfindungsgemäße Diode wird mindestens eine Monolage verwendet, vorzugsweise werden mehrere Monolagen verwendet. Entscheidend ist nun, dass die Kontaktfläche, mit der die Graphenschicht in Kontakt mit der zweiten Hauptfläche der Isolatorschicht ist, linienhaft ist und direkt die Ebene abschließt, in der sich die Elektronen in der zweidimensionalen Struktur bewegen. Anders als bei der MIG-Diode nach der US-Patentschrift müssen sich die Elektronen und/oder Löcher nicht rechtwinklig aus der Graphenschicht herausbewegen, vielmehr grenzt die Bindungsebene, in der sich die Elektronen bewegen, unmittelbar an die Isolatorschicht an und setzt sich quasi in diese fort. Letzteres ist physikalisch zwar nicht exakt zutreffend, soll aber erläutern, dass nun die Kontaktfläche eine vollständig andere ist, als bei der MIG-Diode nach der US-Patentschrift. Die anmeldungsgemäße Anordnung ist so, dass sich theoretisch die Bindungsebene in die Isolatorschicht fortsetzen könnte.

Bei der MIG-Diode verläuft die Bindungsebene dagegen parallel zu der Isolatorschicht.

Als Isolatorschicht können isolierende oder auch halbisolierende Materialien wie beispielsweise Si02, AI203, hBN, SiN, MoS2 verwendet werden. Der Rest der Graphenschicht, also ausgenommen die Kontaktfläche, ist vorzugsweise eingebettet in isolierendem oder nicht vollständig isolierendem Material, z.B. Si02, Al203, hBN, SiN, MoS2. Die Graphenschicht ist zusätzlich durch eine Zuleitung kontaktiert. Vorzugsweise befindet sich unter der Graphenschicht ein Substrat. Dieses Substrat kann als Träger für die Graphenschicht benutzt werden. Auf dem Substrat kann die Graphenschicht durch Aufwachsen erhalten werden oder die Grafikenschicht wird auf das Substrat aufgebracht. Das Substrat kann isolierend oder leitend sein, wenn es leitend ist, ist die Leitfähigkeit geringer als diejenige der Graphenschicht, welche ohnehin eine hohe Leitfähigkeit aufweist.

Oberhalb der Graphenschicht und des Substrats befindet sich eine Abdeckung. Sie ist in der Regel aus isolierendem oder zumindest halbisolierendem Material hergestellt, hierbei kann wieder Si02, Al203, hBN, SiN, MoS2 verwendet werden.

An der freiliegenden Kontaktfläche ist die Graphenschicht in Kontakt mit einer Isolatorschicht aus isolierendem oder halbisolierendem Material. Auf der anderen Seite dieser Isolierschicht befindet sich eine Metallelektrode, die auch eine Graphenschicht sein kann. Auch andere Ausführungen sind möglich, beispielsweise kann hier eine Halbleiterschicht verwendet werden, insbesondere eine hochdotierte Halbleiterschicht.

Aufgrund des linienhaften Kontaktes, nämlich der sehr kleinen Kontaktfläche, mit der Isolatorschicht, hat die Anordnung relativ geringe Kapazitätswerte. Sie ist daher für Höchstfrequenzanwendungen geeignet. Die Isolatorschicht bildet eine Barriere für Ladungsträger. Der Transport von Ladungsträgern durch die Isolatorschicht hindurch ist aufgrund des Tunneleffektes und/oder thermischer Emission möglich.

Überraschend wurde festgestellt, dass die anmeldungsgemäße Diode eine deutlich höhere Stromdichte aufweist als die MIG-Diode nach dem Stand der Technik. Es wurden Werte bis zu 10⁷ A/cm2 gemessen. Bei der MIG-Diode nach dem Stand der Technik liegen diese Werte bei 10 A/cm2. Dieser Unterschied erscheint auf den ersten Blick ausgesprochen hoch, wurde aber tatsächlich festgestellt. Er wird darauf zurückgeführt, dass die Ladungsträger nunmehr in der Bindungsebene bleiben und nicht erst quer aus dieser heraustreten müssen. Es scheint so, dass die Ankopplung der Graphenschicht in der Bindungsebene an die Isolatorschicht deutlich höhere Ströme ermöglicht als bei der bekannten Anordnung der Graphenschicht mit der Bindungsebene parallel zur Metallelektrode.

Insgesamt zeigen daher die anmeldungsgemäßen MIG-Dioden erhebliche Vorteile gegenüber der bekannten MIG-Diode nach dem US-Patent. Sie haben deutlich geringere Kapazitätswerte und zugleich eine erheblich, wirklich erheblich höhere Stromdichte. Sie eignen sich für THz-Anwendungen, sie sind einsetzbar für flexible Dünnfilmtechnologie.

Die anmeldungsgemäße Diode kann auch für die Spin-Injektion und -extraktion in und aus Graphen verwendet werden, wenn die Metallelektrode ferromagnetisch ist oder aus einem anderen Material mit Spin-Polarisierung besteht.

Die Erfindung betrifft auch ein Verfahren zum Herstellen einer derartigen MIG-Diode. Für die einzelnen Verfahrensschritte können beispielsweise lithografische Verfahren eingesetzt werden, beispielsweise Fotolithografie, Elektronenstrahllithografie und ähnliche Verfahren.

Weitere Vorteile und Merkmale der Erfindung ergeben sich aus den übrigen Ansprüchen sowie der folgenden Beschreibung eines nicht einschränkend zu verstehenden Ausführungsbeispiels der Erfindung, das unter Bezugnahme auf die Zeichnung näher erläutert wird. In dieser Zeichnung zeigen:
- Fig. 1:: eine Draufsicht auf die MIG-Diode, teilweise angeschnitten,
- Fig. 2:: ein Schnitt entlang der Schnittlinie II-II in Fig. 1 und
- Fig. 3:: ein Spannungs/Strom, also V/I-Diagramm der MIG-Diode, auch Kennlinie genannt.

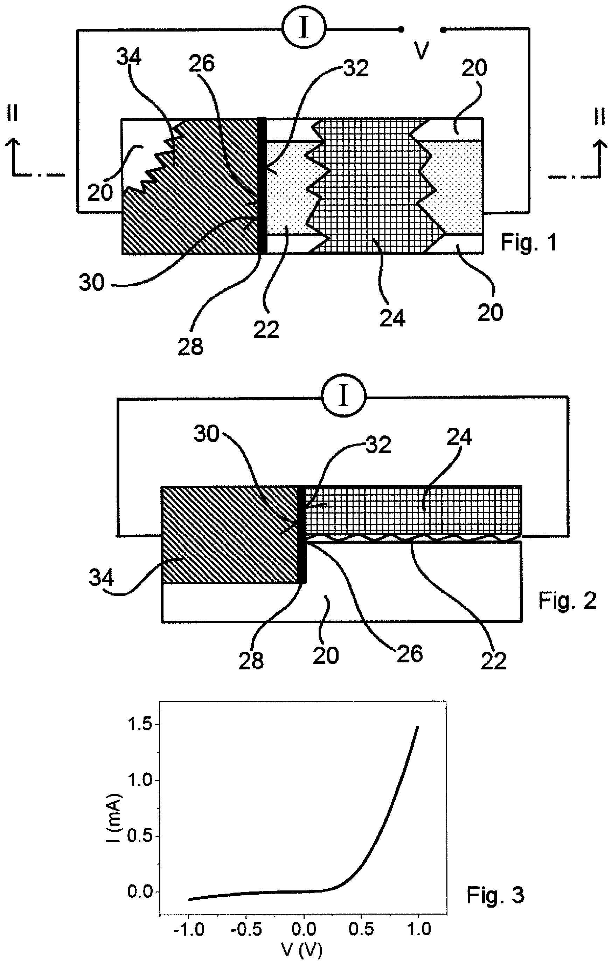

In einem Substrat 20, das sich über die gesamte Grundfläche der in den Fig. 1 gezeigten Diodenanordnung erstreckt, ist eine Stufe ausgebildet, dadurch wird ein höheres und ein tieferes Niveau erhalten, siehe insbesondere Fig. 2. Auf dem höheren Niveau befindet sich eine Graphenschicht 22. Es handelt sich beispielsweise um eine Monolage Graphen. Sie hat eine Dicke zwischen drei und vier nm und eine Breite von 70 nm. Die Breite ist geringer als die Breite des Substrats 20, das etwa 20 bis 50 % breiter ist. Dadurch bleiben seitlich der Graphenschicht 22 Bereiche des Substrats 20 frei von der Graphenschicht 22. Oberhalb der Graphenschicht 22 und der Seitenbereiche des Substrats 20 ist eine Abdeckung 24 aufgebracht. Insgesamt ist dadurch die Graphenschicht 22 im Wesentlichen gekapselt. Sie ist lediglich an zwei Stirnseiten frei. Eine Stirnseite endet an der Stufe. Sie wird als Kontaktfläche 26 bezeichnet. Die andere Stirnfläche, die randseitig des Substrats 20 ist, dient einem elektrischen Anschluss, siehe Fig. 1.

Auf die Kontaktfläche 26 ist eine Isolatorschicht 28 aufgebracht. Sie hat eine Dicke von beispielsweise 5,7 nm und ist aus SiO2 oder einem anderen Isolator gefertigt. Sie erstreckt sich von dem tieferen Niveau der Stufe bis zur Oberkante der Abdeckung 24, in Breitenrichtung erstreckt sie sich über die gesamte Breite des Substrats 20. Eine derartige Ausbildung ist für die Herstellung günstig aber nicht notwendig. Es kann auch eine kleinere Isolatorschicht 28 vorgesehen sein. Die Isolatorschicht 28 hat eine erste Hauptfläche 30 und eine zweite Hauptfläche 32, letztere ist der Graphenschicht 22 zugewandt. Die Kontaktfläche 26 hat einen Flächeninhalt, der deutlich geringer ist als die Fläche der zweiten Hauptfläche 32, insbesondere ist letztere mindestens 10 mal, insbesondere mindestens 100 mal größer.

In dem tieferen Niveau ist eine Metallelektrode 34 angeordnet. Sie bedeckt die erste Hauptfläche 30 und bildet eine Kondensatorplatte.

Figur 3 zeigt eine typische Kennlinie einer Diode. Im positiven Spannungsbereich V größer null sie zunehmend stromleitend. Im negativen Spannungsbereich sperrt sie. Bei plus 1 Volt liegt ein Strom von etwa 1,5 mA vor. Dieser Strom fließt durch die Kontaktfläche 26, deren Flächeninhalt 2,8 10⁻¹⁰ cm2 beträgt. Die Stromdichte bei plus 1 Volt ist daher 5 x 10⁶ A/cm2.

Als Metall für die Metallelektrode 34 können übliche Metalle wie AI, Ti, Au usw., auch Halbleiter wie Si, insbesondere p-oder n-dotiert, oder ferromagnetische Metalle, wie beispielsweise Ni, Fe oder Co verwendet werden. Die Isolatorschicht 28 hat typischerweise eine Dicke von 1 bis 15 nm. Die Graphenschicht 22 kann eine Monolage sein, sie kann aber auch viele Monolagen übereinander sein, typischerweise bis zu dreiunddreißig Monolagen. Durch Ändern dieser Dicke wird die Kapazität verändert. Sie wird ebenso durch Ändern der Breite der Graphenschicht 22 zwischen beispielsweise 10 nm und 150 nm verändert. Damit ändert sich die Arbeitsfrequenz. Es können auf diese Weise aber auch die Stromwerte beeinflusst werden.

Substrat 20 und/oder Abdeckung 24 sind im Wesentlichen passiv. Beide sind isolierend oder zumindest halbisolierend. In der Regel sind beide nicht aktiv an den physikalischen Vorgängen, die sich in der Diode abspielen, beteiligt. Sie sind vorteilhaft für die Herstellung und für den mechanischen Zusammenhalt der Diode. Sie können nach der Herstellung der Diode selbst durchaus entfernt werden, wenn dies gewünscht wird, zumindest können sie reduziert werden.

Es ist möglich, das Substrat 20 in gewissem Maße leitend auszubilden, beispielsweise halbleitend. Dann sollte eine Isolatorlage zwischen der Metallelektrode 34 und dem Substrat 20 vorgesehen sein. Dadurch ist eine elektrische Verbindung zwischen Substrat 20 und Metallelektrode 34 unterbrochen. Es besteht aber eine elektrische Verbindung zwischen Substrat 20 und der Graphenschicht 22. Letztere hat eine deutlich höhere, vorzugsweise zumindest 10-mal höhere Leitfähigkeit als das Substrat 20. An das Substrat 20 kann eine Spannung angelegt werden, beispielsweise auch eine Wechselspannung.

Bei dem Herstellungsverfahren wird ausgegangen von einem Substrat 20. Eine Graphenschicht 22 wird auf das Substrat 20 aufgebracht oder direkt auf diesem hergestellt. Anschließend wird die Abdeckung 24 auf der Graphenschicht 22 und seitlich davon in den Seitenbereichen aufgebracht, dies kann durch eine beliebige Dünnschichttechnologie erfolgen, beispielsweise durch physikalische oder chemische Ablagerung (Aufdampfen, Sputtern), Epitaxie usw.. Die Abdeckung 24 ist nicht grundsätzlich erforderlich, sie kann entfallen oder auch entfernt werden, wenn ein seitlicher Kontakt ausgebildet werden kann.

Anschließend wird die erhaltene Schichtanordnung geätzt, dies kann durch trockenes oder nasses Ätzen, physikalisch oder chemisch, erfolgen, auf diese Weise wird eine Kontaktfläche 26 der Graphenschicht 22 freigelegt. Auf dieser wird nun die Isolatorschicht 28 ausgebildet. Dies kann durch Atomlagenabscheidung unter Bildung von TiO2 erfolgen, andere Verfahren und andere Substanzen können ebenfalls eingesetzt werden, beispielsweise physikalisches Ablagern (Aufdampfen, Sputtern usw.), chemisches Aufbringen (chemical vapor deposition), weiterhin durch Epitaxie usw.. Die Isolatorschicht 28 erstreckt sich dabei über eine Fläche, die deutlich größer ist als die Kontaktfläche 26. Oben und unten und links und rechts ragt die Isolatorschicht 28 über die Kontaktfläche 26 hinaus. Anders ausgedrückt befindet sich die Kontaktfläche 26 in einem Abstand von den Rändern der Isolatorschicht 28. Dieser Abstand beträgt mindestens 2, bevorzugt 5, und insbesondere mindestens 10 nm. Vorzugsweise liegt er bei deutlich größeren Werten.

Schließlich wird die Metallelektrode 34 auf die Isolatorschicht 28 aufgebracht und elektrisch angeschlossen.

Der Dickenbereich der Graphenschicht 22 liegt zwischen 0,3 bis 100 nm. Die Breite der Graphenschicht 22 liegt vorzugsweise zwischen 10 nm und mehreren Zentimetern. Letzteres Maß wird nicht als kritisch erachtet. Die Breite beeinflusst offensichtlich nicht die Arbeitsweise der Diode. Die Breite kann auf denjenigen Wert gesetzt werden, der einen gewünschten Stromwert liefert.

Die Metall- Isolator-Graphen Diode besteht aus einer Metallelektrode 34, die eine Elektrodenfläche hat, einer Isolatorschicht 28, die mit einer ersten Hauptfläche 30 in flächigem Kontakt mit der Elektrodenfläche ist, und einer Graphenschicht 22, die eine Kontaktfläche 26 hat. Diese Kontaktfläche 26 ist in linienhaftem Kontakt mit einer zweiten, der Metallelektrode 34 gegenüber liegenden Hauptfläche 30, 32 der Isolatorschicht 28. Die Graphenschicht 22 weist mindestens eine zweidimensionale Monoschicht auf. Die Flächenebene der Graphenschicht 22 verläuft quer zu den Hauptflächen 30, 32.

Vorzugsweise weist die Kontaktfläche 26 der Graphenschicht 22 eine Höhe von ein bis 30 Monolagen Graphen auf. Vorzugsweise hat die Kontaktfläche 26 der Graphenschicht 22 eine Breite von mindestens 10 nm. Vorzugsweise ist ein Substrat 20 vorgesehen, auf dem zumindest die Metallelektrode 34 und die Graphenschicht 22 angeordnet sind. Die Graphenschicht 22 befindet sich vorzugsweise zwischen der Abdeckung 24 und dem Substrat 20. Vorzugsweise ist die Isolatorschicht 28 auf der Graphenschicht 22 ausgebildet, insbesondere durch Atomlagenabscheidung (atomic layer deposition), durch ein physikalisches oder chemisches Abscheideverfahren (physical or chemical deposition), durch Epitaxie oder dergleichen. Die Kontaktfläche 26 der Graphenschicht 22 ist vorzugsweise mindestens zehnmal, insbesondere mindestens 100-mal kleiner ist als die Elektrodenfläche. Die Isolatorschicht 28 ist vorzugsweise aus einem isolierenden oder zumindest teilweise isolierenden Material erstellt. Die Isolatorschicht 28 hat insbesondere eine Dicke von 1-15 nm. Das Substrat 20 ist vorzugsweise elektrisch von der Metallelektrode 34 isoliert. Das Substrat 20 kann eine Leitfähigkeit aufweisen.

Begriffe wie im Wesentlichen, vorzugsweise und dergleichen sowie möglicherweise als ungenau zu verstehende Angaben sind so zu verstehen, dass eine Abweichung um plusminus 5 %, vorzugsweise plusminus 2 % und insbesondere plus minus ein Prozent vom Normalwert möglich ist. Die Anmelderin behält sich vor, beliebige Merkmale und auch Untermerkmale aus den Ansprüchen und/oder beliebige Merkmale und auch Teilmerkmale aus einem Satz der Beschreibung in beliebiger Art mit anderen Merkmalen, Untermerkmalen oder Teilmerkmalen zu kombinieren, dies auch außerhalb der Merkmale unabhängiger Ansprüche.

### Hinweis auf Förderung

Das Projekt, das zu diesem Antrag geführt hat, wurde im Rahmen der Finanzhilfevereinbarung Nr. 649953 und der entsprechenden Teilproiekte aus dem Forschungs- und Innovationsprogramm "Horizont 2020" der Europäischen Union finanziert.

### Bezugszeichenliste

- 20: Substrat
- 22: Graphenschicht
- 24: Abdeckung
- 26: Kontaktfläche
- 28: Isolatorschicht
- 30: erste Hauptfläche
- 32: zweite Hauptfläche
- 34: Metallelektrode

## Patentansprüche

1. Metall- Isolator-Graphen Diode bestehend aus einer Metallelektrode (34), die eine Elektrodenfläche hat, einer Isolatorschicht (28), die mit einer ersten Hauptfläche (30) in flächigem Kontakt mit der Elektrodenfläche ist, und mit einer Graphenschicht (22), die eine Kontaktfläche (26) hat, welche Kontaktfläche (26) in linienhaftem Kontakt mit einer zweiten, der Metallelektrode (34) gegenüber liegenden Hauptfläche (30, 32) der Isolatorschicht (28) ist, wobei die Graphenschicht (22) mindestens eine zweidimensionale Monoschicht aufweist und die Flächenebene der Graphenschicht (22) quer zu den Hauptflächen (30, 32) verläuft.

2. Metall- Isolator-Graphen Diode nach Anspruch 1, **dadurch gekennzeichnet, dass** die Kontaktfläche (26) der Graphenschicht (22) eine Höhe von ein bis 30 Monolagen Graphen aufweist.

3. Metall- Isolator-Graphen Diode nach einem der vorangegangenen Ansprüche, **dadurch gekennzeichnet, dass** die Kontaktfläche (26) der Graphenschicht (22) eine Breite von mindestens 10 nm aufweist.

4. Metall- Isolator-Graphen Diode nach einem der vorangegangenen Ansprüche, **dadurch gekennzeichnet, dass** sie weiterhin ein Substrat (20) aufweist, auf dem zumindest die Metallelektrode (34) und die Graphenschicht (22) angeordnet sind.

5. Metall- Isolator-Graphen Diode nach Anspruch 4, **dadurch gekennzeichnet, dass** sie weiterhin eine Abdeckung (24) aufweist, und dass sich die Graphenschicht (22) zwischen der Abdeckung (24) und dem Substrat (20) befindet.

6. Metall- Isolator-Graphen Diode nach einem der vorangegangenen Ansprüche, **dadurch gekennzeichnet, dass** die Isolatorschicht (28) auf der Graphenschicht (22) ausgebildet ist, insbesondere dass sie durch Atomlagenabscheidung (atomic layer deposition), durch ein physikalisches oder chemisches Abscheideverfahren (physical or chemical deposition), durch Epitaxie oder dergleichen erstellt ist.

7. Metall- Isolator-Graphen Diode nach einem der vorangegangenen Ansprüche, **dadurch gekennzeichnet, dass** die Kontaktfläche (26) der Graphenschicht (22) mindestens zehnmal, insbesondere mindestens 100-mal kleiner ist als die Fläche der Metallelektrode (34).

8. Metall- Isolator-Graphen Diode nach einem der vorangegangenen Ansprüche, **dadurch gekennzeichnet, dass** die Isolatorschicht (28) aus einem isolierenden oder zumindest teilweise isolierenden Material besteht.

9. Metall- Isolator-Graphen Diode nach einem der vorangegangenen Ansprüche, **dadurch gekennzeichnet, dass** die Isolatorschicht (28) eine Dicke von 1-15 nm aufweist.

10. Metall- Isolator-Graphen Diode nach einem der Ansprüche 4 - 9, **dadurch gekennzeichnet, dass** das Substrat (20) elektrisch von der Metallelektrode (34) isoliert ist, und dass das Substrat (20) eine Leitfähigkeit aufweist.

11. Verfahren zum Herstellen einer Metall- Isolator-Graphen Diode nach einem der vorangegangenen Ansprüche mit folgenden Verfahrensschritten
a) Bereitstellen eines Substrats,
b) Aufbringen oder Aufwachsenlassen einer Graphenschicht (22) auf dem Substrat (20),
c) Aufbringen einer Abdeckung (24) auf der Graphenschicht (22),
d) Ätzen der so gewonnenen Schichtanordnung, um einen Teilbereich der Graphenschicht (22) freizulegen, der quer zu der Flächenebene der Graphenschicht (22) verläuft,
e) Ausbilden einer Isolatorschicht (28) auf dem Teilbereich, und
f) Ausbilden der Metallelektrode (34) auf der freien Seite der Isolatorschicht (28).

12. Verfahren nach Anspruch 11, **dadurch gekennzeichnet, dass** zumindest einer der Schritte c), e) und f) durch Dünnfilm-Technik, ein physikalisches oder chemisches Abscheideverfahren, Aufdampfen, Sputtern, Atomlagenabscheidung (atomic layer deposition), Epitaxie usw. erfolgt.

## Claims

1. A metal-insulator-graphene diode, consisting of a metal electrode (34) having an electrode surface, an insulator layer (28) which, with a first main surface (30), is in planar contact with the electrode surface, and with a graphene layer (22) having a contact surface (26), which contact surface (26) is in a line-shaped contact with a second main surface (30, 32), which is opposite the metal electrode (34), of the insulator layer (28), wherein the graphene layer (22) has at least one two-dimensional monolayer and the surface plane of the graphene layer (22) extends transversely to the main surfaces (30, 32).

2. The metal-insulator-graphene diode according to claim 1, **characterized in that** the contact surface (26) of the graphene layer (22) has a height of one to 30 monolayers of graphene.

3. The metal-insulator-graphene diode according to any one of the preceding claims, **characterized in that** the contact surface (26) of the graphene layer (22) has a width of at least 10 nm.

4. The metal-insulator-graphene diode according to any one of the preceding claims, **characterized in that** it further has a substrate (20) on which at least the metal electrode (34) and the graphene layer (22) are disposed.

5. The metal-insulator-graphene diode according to claim 4, **characterized in that** it further has a cover (24), and that the graphene layer (22) is located between the cover (24) and the substrate (20).

6. The metal-insulator-graphene diode according to any one of the preceding claims, **characterized in that** the insulator layer (28) is formed on the graphene layer (22), in particular, that it is produced by atomic layer deposition, by a physical or chemical deposition method, by epitaxy or the like.

7. The metal-insulator-graphene diode according to any one of the preceding claims, **characterized in that** the contact surface (26) of the graphene layer (22) is at least ten times, in particular at least 100 times smaller than the surface of the metal electrode (34).

8. The metal-insulator-graphene diode according to any one of the preceding claims, **characterized in that** the insulator layer (28) consists of an insulating or at least partially insulating material.

9. The metal-insulator-graphene diode according to any one of the preceding claims, **characterized in that** the insulator layer (28) has a thickness of at least 1-15 nm.

10. The metal-insulator-graphene diode according to any one of the claims 4 - 9, **characterized in that** the substrate (20) is electrically insulated from the metal electrode (34), and that the substrate (20) has a conductivity.

11. A method for producing a metal-insulator-graphene diode according to any one of the preceding claims, with the following method steps
a) providing a substrate,
b) applying a graphene layer (22) to the substrate (20) or letting it grow thereon,
c) applying a cover (24) to the graphene layer (22),
d) etching the layer arrangement thus obtained in order to expose a partial area of the graphene layer (22) which extends transversely to the surface plane of the graphene layer (22),
e) forming an insulator layer (28) on the partial area, and
f) forming the metal electrode (34) on the free side of the insulator layer (28).

12. The method according to claim 11, **characterized in that** at least one of the steps c), e) and f) is carried out by means of a thin-film technique, a physical or chemical deposition method, vapor deposition, sputtering, atomic layer deposition, epitaxy etc.

## Revendications

1. Diode métal-isolant-graphène consistant en une électrode métallique (34) qui présente une surface d'électrode, une couche isolante (28) qui a une première surface principale (30) en contact plat avec la surface d'électrode, et une couche de graphène (22) qui présente une surface de contact (26), laquelle surface de contact (26) est en contact linéaire avec une deuxième surface principale (30, 32) de la couche isolante (28), laquelle est opposée à l'électrode métallique (34), dans laquelle ladite couche de graphène (22) comprend au moins une monocouche bidimensionnelle et le plan de surface de la couche de graphène (22) s'étend transversalement aux surfaces principales (30, 32).

2. Diode métal-isolant-graphène selon la revendication 1, **caractérisée par le fait que** la surface de contact (26) de la couche de graphène (22) présente une hauteur comprise entre une et 30 monocouches de graphène.

3. Diode métal-isolant-graphène selon l'une quelconque des revendications précédentes, **caractérisée par le fait que** la surface de contact (26) de la couche de graphène (22) présente une largeur d'au moins 10 nm.

4. Diode métal-isolant-graphène selon l'une quelconque des revendications précédentes, **caractérisée par le fait qu'**elle comprend en outre un substrat (20) sur lequel sont disposées au moins l'électrode métallique (34) et la couche de graphène (22).

5. Diode métal-isolant-graphène selon la revendication 4, **caractérisée par le fait qu'**elle comprend en outre une couverture (24), et que la couche de graphène (22) est située entre ladite couverture (24) et le substrat (20).

6. Diode métal-isolant-graphène selon l'une quelconque des revendications précédentes, **caractérisée par le fait que** la couche isolante (28) est réalisée sur la couche de graphène (22), en particulier qu'elle est réalisée par dépôt de couche atomique (atomic layer déposition), par un procédé de dépôt physique ou chimique (physical or chemical déposition), par épitaxie ou similaire.

7. Diode métal-isolant-graphène selon l'une quelconque des revendications précédentes, **caractérisée par le fait que** la surface de contact (26) de la couche de graphène (22) est au moins dix fois, en particulier au moins 100 fois plus petite que la surface de l'électrode métallique (34).

8. Diode métal-isolant-graphène selon l'une quelconque des revendications précédentes, **caractérisée par le fait que** la couche isolante (28) est constituée d'un matériau isolant ou au moins partiellement isolant.

9. Diode métal-isolant-graphène selon l'une quelconque des revendications précédentes, **caractérisée par le fait que** la couche isolante (28) présente une épaisseur comprise entre 1 et 15 nm.

10. Diode métal-isolant-graphène selon l'une quelconque des revendications 4 à 9, **caractérisée par le fait que** le substrat (20) est électriquement isolé de l'électrode métallique (34), et que le substrat (20) présente une conductivité.

11. Procédé de production d'une diode métal-isolant-graphène selon l'une quelconque des revendications précédentes, comprenant les étapes de procédé suivantes consistant à
a) fournir un substrat,
b) appliquer ou faire croître une couche de graphène (22) sur le substrat (20),
c) appliquer une couverture (24) sur la couche de graphène (22),
d) graver l'agencement de couches ainsi obtenu afin d'exposer une zone partielle de la couche de graphène (22), qui s'étend transversalement au plan de surface de la couche de graphène (22),
e) former une couche isolante (28) sur la zone partielle, et
f) former l'électrode métallique (34) sur la face libre de la couche isolante (28).

12. Procédé selon la revendication 11, **caractérisé par le fait qu'**au moins l'une des étapes c), e) et f) est mise en œuvre par la technologie de couche mince, un procédé de dépôt physique ou chimique, l'évaporation sous vide, la pulvérisation cathodique, le dépôt de couche atomique (atomic layer déposition), par épitaxie, etc.
